# EUROPEAN PATENT APPLICATION

(11) **EP 1 253 433 A1**
(43) Date of publication of application: **30.10.2002**
(21) Application number: 01303682.7
(22) Date of filing: 23.04.2001
(51) Int. Cl.: G01R 33/343

(54) **Magnetic resonance probe**

(71) Applicant: ERA PATENTS LIMITED, Leatherhead Surrey KT22 7SA (GB)
(72) Inventor: Pedder, Donald Austin Grant, Walton-on-Thames, Surrey KT12 1LE (GB); Mann, Kenneth Robert, Caterham, Surrey CR3 5TR (GB); Hunt, Nigel George Ian, Fetcham, Surrey KT22 9LY (GB)
(74) Representative: Rackham, Stephen Neil

(57) **Abstract**

A probe suitable for use in a magnetic resonance based (such as NMR or NQR) material detection and/or analysis system. The probe is designed to improve sensitivity to signals generated within a sample volume and at the same time to improve insensitivity to background noise. The design also improves the ease with which samples may be placed within the probe. The probe is of an extended toroidal design of a generally "running track" shape having two semi-circular shaped ends separated by straight parallel sides. A gap is provided in one of the straight parallel sides to allow insertion and removal of samples. The probe is suitable for use with a continuous feed of samples such as on a conveyor belt. Various forms of the probe are described, some of which are particularly suited to increased portability.

## Description

The present invention relates to a probe which is suitable for use in a Magnetic Resonance based material detection and/or analysis system and in particular, though not solely to Nuclear Quadrupole Resonance (NQR) detection and/or analysis of materials, including the detection of contraband such as explosives or narcotics.

NQR is a technique suitable for the detection and/or analysis of bulk materials, including the possibility of measuring properties such as strain, pressure, temperature, purity or quantity. NQR is a magnetic resonance technique that uses a sequence of Radio Frequency (RF) magnetic field pulses to investigate a sample and then detects the (small) magnetic response. Key parts of a system include a spectrometer, an RF switching and amplification stage and a probe.

The spectrometer generates an RF pulse sequence and also collects and processes the signals generated by the sample. The RF switching and amplification stage receives and amplifies the pulse sequence generated by the spectrometer to produce high power transmit pulses and then switches in sensing circuitry to allow extremely low power signals to be received and analysed. The probe converts the electrical energy of the pulse sequence into a magnetic field (when transmitting) and also converts magnetic responses from samples into electrical energy for subsequent analysis.

NQR is a magnetic resonance technique closely related to Nuclear Magnetic Resonance NMR. With NMR an externally applied DC magnetic field is applied to align the magnetic spins within the material. The transition frequency applied to excite a response is typically between 10 MHZ and 100 MHZ. In NQR analysis the magnetic spins of the sample under test are aligned naturally due to the interaction between the quadrupolar nuclei being examined and the electric field environment in which those nuclei reside both on a molecular and on a crystalline level. Due to the weaker alignments of the magnetic spins in NQR the transition energies are typically lower. These transitions typically occur at frequencies between 0.5 MHZ and 10 MHZ.

NQR analysis can be used to specifically detect bulk materials which contain a quadrupolar nucleus. Examples of such materials are explosives such as RDX, TNT and PETN that contain nitrogen and narcotics such as heroin and cocaine that contain chlorine. The signatures for a given material are extremely specific as each material will have specific transition (or detection) frequencies and at each of these detection frequencies the signals will have unique decay times. Additionally, the decay times and transition frequencies can vary somewhat dependent on the purity of the material, its temperature and the strain it is under, see for example US-A-5457385.

The NQR technique has been widely used for the detection of contraband, see for example US-A-5206592, US-A-5592083 and US-A-5206592. A problem with the technique is the low signal to noise ratios observed when attempting to detect or analyse samples. The low S/N ratios make the technique susceptible to problems due to interference from sources of electrical noise such as switching transients and the signals from radio stations that may act to mask true signals. Various methods have been used to mitigate for the combination of low signal to noise ratios and the presence of interference signals. These methods include the use of shielding as discussed in US-A-5592083 mentioned above. Another method used to reduce this problem is the cancellation of noise using two receiver probes one which has been used to pick up the signal as well as noise and a second which has detected noise signals only as discussed in WO-A-9945408. A further approach that has been suggested by a number of parties is the use of a gradiometric probe which detects signals from nearby samples whilst rejecting noise from distant sources and this is discussed in US-A-6054856.

The present invention relates to a probe design which is very sensitive to signals generated within the sample volume but, due to its geometry, is very insensitive to signals (that is, interference) generated in places distant from the sample volume. Due, also, to the probe's geometry it is suited to having shielding placed closer to it than other probe designs. The design described here is an extended toroidal design, a non-extended toroidal design has been used in NQR before in "Toroidal Sample Coil for Nuclear Quadrupole Resonance Experiments at High Pressure", Rev. Sci Instrum., Vol 47, No. 3, March 1976; p388-390 but in this case the toroidal coil was wound around the sample and easy insertion of various samples was impossible. Toroidal cavity resonators have also been used in NMR in the past but again only with poor accessibility to the sample volume and with this type of resonator very inhomogeneous fields are generated. The present invention has, as a key feature, easy insertion and removal of samples. It also has low susceptibility to externally generated noise and compared with the other examples of toroidal probes used in nuclear magnetic resonance techniques it has much greater field homogeneity.

Further examples of existing probe designs include solenoids in which a sample is placed and loops or short solenoids which are frequently used to examine samples that cannot be placed within the inspection system (for example, landmines in the ground). Both of these coil types exhibit a similar field pattern that is extensive compared with the size of the probe itself. In the case of the solenoid that has samples placed within it, complete or partial shielding can be used to greater or lesser effect respectively to reduce susceptibility to generating and receiving interference. However, the shielding must be significantly larger than the probe itself otherwise it will impact detrimentally on the probe's performance. Loop probes or short solenoids also extensively project fields and single sided use reduces the scope for applying shielding, they are therefore prone to generating and picking up interference. Gradiometric coil designs such as the use of anti-Helmholtz coils or figure of eight coils also generate fields which are much more extensive than the probes themselves. The projection of extensive fields increases the susceptibility to both picking up and generating interference and also results in the need for any shielding used to mitigate this problem to be of very high quality and somewhat distanced from the probe if it is to be effective.

Existing probes suitable for use in magnetic resonance based detection and/or analysis systems are therefore inefficient in their use of the generated magnetic field and the magnetic response produced by the sample. Existing probe designs are also generally susceptible to generation and reception of extraneous electromagnetic signals and their designs generally lead to difficultly in insertion and removal of samples.

It is therefore an object of the present invention to provide a probe which will go at least some way towards overcoming or minimising the above disadvantages.

Accordingly, in a first aspect, the invention consists in a probe suitable for use in a magnetic resonance based material detection and/or analysis system, the probe comprising:
a probe body having a base portion and two arm portions, the arm portions extending from the two ends of the base portion so that their distal ends are directed towards one another and separated by a gap in which a sample of the material may be positioned,
inductance means adapted to receive electrical energy from the magnetic resonance based material detection and/or analysis system and produce a magnetic field within the inductance means, and
capacitance means connected to the inductance means,
wherein the base portion and the two arm portions of the probe body are hollow and the inductance means is provided on the base and arm portions of the probe body.

Preferably, the probe body has a stretched toroidal shape having two semi-circular arm portions separated by a straight base portion with the gap provided opposite the base portion.

Preferably, the probe body is formed in a substantially running track shape having two curved ends separated by parallel straight sections with the base portion forming one of the parallel straight sections, the two arm portions forming the respective curved ends and the gap positioned in the other of the parallel straight sides.

Preferably, the base portions and the two arm portions have rectangular or square cross-sections.

Preferably, the capacitance means are adjustable thereby allowing the resonant frequency of the system and hence the magnetic field within the probe body to be adjusted.

Preferably a plurality of adjustable capacitance means are provided connected to the inductance means and adjustment of the resonant frequency is accomplished by selectively connecting some or all of the plurality of adjustable capacitance means to the inductance means.

Preferably, inductance adjustment means comprising means to adjust the cross-sectional area of a segment of the probe body are also provided allowing the frequency of the magnetic field within the inductance means to be adjusted.

Preferably, the inductance means is a conductive layer covering substantially the entire outer surface of a substrate forming the probe body.

Alternatively, the inductance means is a conductive layer covering some of the outer surface of a substrate forming the probe body and includes regularly spaced cutout portions where no conductive layer is provided on the substrate.

Preferably, the probe includes an outer electrically conductive electromagnetic shielding layer surrounding the inductance means and a door is provided in the shielding layer adjacent the gap to allow the introduction and removal of material samples to the gap.

Preferably, two doors are provided in the shielding layer adjacent respective opposite sides of the gap.

Alternatively, the probe includes an outer electrically conductive electromagnetic shielding layer surrounding the probe body and two openings are provided in the shielding layer adjacent opposite sides of the gap and respective tunnel means are connected to the shielding layer surrounding the respective openings.

Preferably, means are also provided to remove electrical energy from the magnetic field within the probe.

Preferably the base and arm portions of the probe body are formed in a number of releasably or flexibly connectable body panel sections to allow the probe to be repeatedly assembled and disassembled or expanded and compressed.

In a further aspect, the invention consists in a magnetic resonance based material detection and/or analysis system comprising:
a probe according to the first aspect,
radio frequency pulse generating means connected to the probe to produce an applied magnetic field within the probe body,
sensing means for detecting a magnetic field produced by the material sample as a result of the applied magnetic field, and
control means to selectively energise either the radio frequency pulse generating means or the sensing means.

Preferably, conveying means are also provided to transport material samples into and out of the gap in the probe.

Preferably, the sensing means and/or the radio frequency pulse generating means are inductively, capacitively or directly coupled to the probe at respective single positions or at a plurality of respective positions.

Particular embodiments of the invention will now be described with reference to the accompanying drawings in which:
Figure 1 is a perspective view of a probe in accordance with a first particular embodiment of the present invention;
Figure 2 is a schematic diagram of the main components of a magnetic resonance based material detection and/or analysis system including the probe of Figure 1 encased in an electromagnetic shielding case;
Figures 3A and 3B are exemplary equivalent circuit diagrams of the resonant LC circuit of the probe of Figure 1;
Figure 4 is a cross-sectional elevation through the base portion of the probe of Figure 1 showing the inductance tuning vane;
Figure 5 is a cross-sectional side elevation of a second particular embodiment of the invention in which a conveyor feeds samples into and out of the gap in the probe;
Figures 6A, 6B and 6C are circuit diagrams respectively showing the incorporation of a directly connected, inductively coupled and capacitively coupled dissipative circuit into the resonant circuit of the probe shown in Figure 1; and
Figures 7A, 7B and 7C are plan views respectively of a foldable probe according to the present invention in open, partly open and closed configurations.

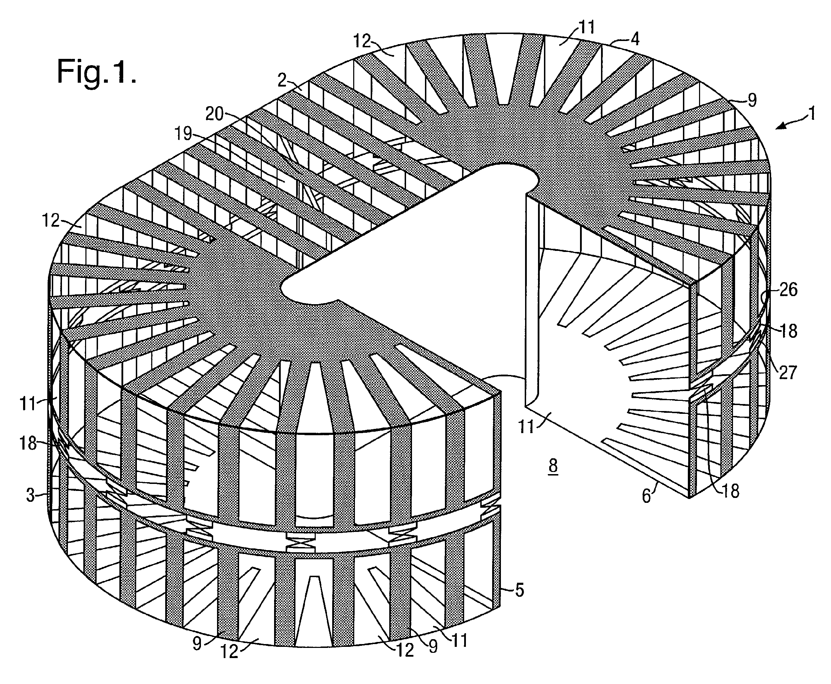

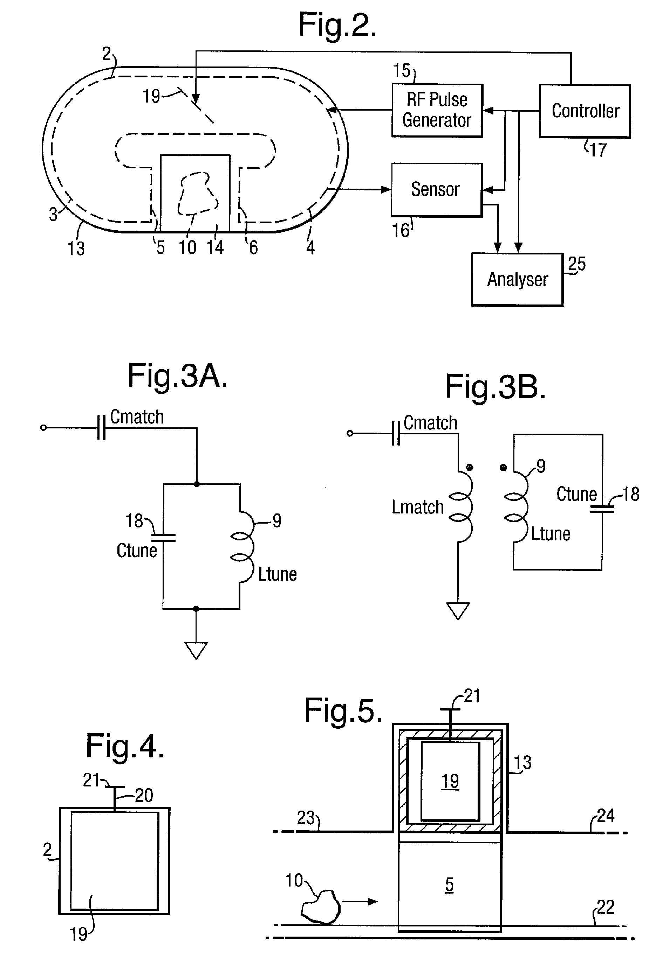

With reference to the drawings and in particular Figure 1, a probe 1 is shown which includes a probe body including a base portion 2 and two arm portions 3 and 4. In the embodiment shown in Figure 1, the probe 1 has a substantially "running track" shape wherein the base portion 2 forms one of the parallel straight sides and the arm portions 3 and 4 form the respective curved ends. The ends 5 and 6 of the arm portions extend towards one another and are separated by a gap 8 which is positioned in the other parallel side of the racing track shape. The gap 8 is adapted to receive a sample 10 of material to be analysed (see Figure 2).

It can be seen that the cross-sectional shape of the probe is constant around the entire probe and preferably this is rectangular or square but may also be circular. Accordingly, the probe 1 has a shape which may be described as a toroid which has been stretched to provide two parallel opposite sides, one of which is provided with the gap 8.

The probe body 1 may be formed from a non-conducting substrate or frame 11 such as wood or plastic. A conducting coil 9 is wound around the base 2 and arm 3, 4 portions of the probe body. While the coil 9 could be a conventional coil formed from a large number of turns of a single wire, it is preferred that a layer of metal 9, for example copper, is provided on the substrate for example by wrapping sheet copper, deposition or metallisation techniques.

The metal layer 9 may be provided substantially over the entire surface of the probe body (except for the end faces 5 and 6 of the arm portions 3 and 4). Alternatively however, as shown in Figure 1, cutout portions 12 (in which there is no metal layer provided and therefore substrate 11 is visible) are regularly provided around the probe body in which there is no metal layer provided and therefore the substrate 11 is visible. The metal layer may therefore be formed for example as bands, ribs or slots and this design enables the weight of the probe to be reduced and therefore improves the portability of the probe. It can be seen in Figure 1 that copper bands 26 and 27 are provided substantially continuously around the outside of the toroidal shaped body of the probe in order to ensure that electrical continuity of the coil is maintained with all of the bands, ribs or slots of the coil.

With reference now to Figure 2, an outer electrically conductive shielding layer 13 is provided which may be placed very closely outside the probe body. The shield 13 reduces the effect of external magnetic fields and also helps to constrain the generated magnetic and electric fields within the probe. In order to allow the sample 10 to be positioned in the gap 8 when the shield 13 is provided, a door is formed in the shield, adjacent the gap.

As can be seen in Figure 2, the probe forms part of a magnetic resonance (for example NQR) based material detection and/or analysis system which also includes an RF pulse generator which is connected to the coil 9 to provide electrical energy in the form of high power pulses to the coil. The probe converts the electrical energy in the pulses into a magnetic field within the probe. In response to the applied magnetic field from the probe, the sample 10 produces its own small magnetic field which is detected by sensor 16. Signals representative of the magnetic field detected by sensor 16 are input to an analyser 25 (which may comprise computer software analysis) and the results of the analysis are subsequently output. A controller 17 ensures that the RF pulse generator 15 and the sensor 16 are energised at appropriate times.

Referring back to Figure 1, tuning capacitors 18 are provided in the probe body and are electrically connected to the coil 9 to form a series or parallel resonant LC circuit depending on the manner of power feed. The capacitance of the tuning capacitors 18 are adjustable either by using variable capacitors or by using switches to add or subtract capacitance. The inductance of coil 9 is also variable by a tuning vane 19 (see also Figure 4) provided within the hollow central portion of the probe. The tuning vane 19 could be positioned in the base portion 2 and/or either arm portion 3,4 and comprises a conductive plate or loop mounted on a pivot axle 20 passing through the probe. The pivot axle 20 may be rotated (manually via a handle 21 or under control of controller 17) to effectively reduce the cross-sectional area of a segment of the probe body, interrupting the flux path within the coil 9 to a variable degree, thereby finely adjusting the inductance of the coil.

Alternative exemplary equivalent circuit diagrams of the effective electrical tuned circuit of the probe are shown in Figures 3A and 3B. The probe may have series and/or parallel connected inductance and capacitance. In the circuits of both Figures 3A and 3B a matching capacitance C_{match} is included between the input and the resonant circuit. In Figure 3B a matching inductance L_{match} is also included as the resonant circuit is inductively coupled to the input.

Figure 5 shows an alternative embodiment of the invention suitable for detecting and/or analysing a large number of samples wherein a conveying means such as a conveyor belt 22 is provided through the gap 8 in probe 1. The conveyor belt may be continually moved or incremented under control of controller 17 to pass a series of samples through the probe. It is preferred that this embodiment also include the shield 13 and therefore openings are provided in opposite sides of the shield, adjacent opposite sides of the gap 8. Tunnels 23 and 24 may be connected to the shield through which the conveyor belt passes. If long enough, the tunnels will act as wave-guides below their cut-off frequency, thereby attenuating the interactions between the probe and the outside world.

One advantage of the probe according to the invention is its low susceptibility to transmitting and receiving noise while still allowing samples to be readily emplaced and removed. In addition the device is a particularly efficient magnetic structure with nearly all of the magnetic flux generated by the system constrained within it. This allows high quality factors to be obtained if careful construction is employed which, in turn, leads to high power efficiency and improved signal to noise ratio from samples under test.

The resonant frequency of the device can be fine-tuned either by adjusting the capacitance 18 or inductance 9 of the tuned circuit. This can be accomplished with continuously variable components such as the tuning capacitors or the tuning vane. Alternatively the capacitance or inductance can be incrementally adjusted by switching tuning capacitance in and out or by switching different sized conductive loops (not shown) which are wound within the base and/or arms of the probe and which block different amounts of flux, adjusting the probe's inductance. Coarse switching of the probe's resonant or tuning frequency is best achieved by switching the resonant circuit's tuning capacitance.

Energy from the RF pulse generator 15 to the probe and energy from the probe to sensor 16 can be directly or indirectly capacitively or inductively coupled. Also, the transfer of energy between probe and sensor can take place from one point on the probe or could be distributed around the probe.

To provide improved results it is desirable to allow removal of energy from the applied magnetic field within the probe in order to allow the small magnetic resonance signals from the sample to be accurately measured. This can be achieved by connecting a dissipative load circuit or circuits to the probe. The dissipative circuit(s) can be connected directly, or indirectly to the probe via capacitive or inductive coupling.

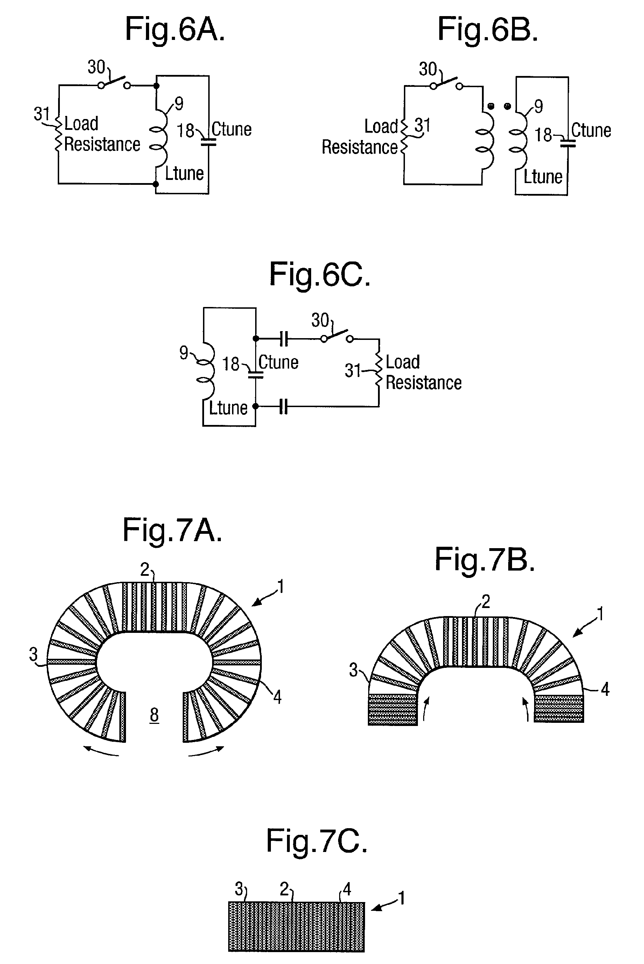

The dissipative circuit could consist of a resistive load 31 that is switched into the main resonant circuit reducing its quality factor by a large amount, thus removing its ability to store energy efficiently. The resistive load can be coupled to the main tuned circuit (Cₜᵤₙₑ and Lₜᵤₙₑ) either directly as in Figure 6A, inductively coupled as in Figure 6B or capacitively coupled as in Figure 6C. The resonant circuit should have a high quality factor when efficiently generating a magnetic field for the purpose of exciting a signal in a sample. After the sample has been excited the resonant circuit's quality factor should be reduced to remove all stored energy, once this has occurred the high quality factor should be reinstated to allow the efficient detection of signals generated within the sample. The switching in and out of the load resistance between these states by switch 30 should be accomplished without the introduction of switching transients as these will have the effect of re-introducing energy which will be stored by the resonant circuit and will therefore act to mask the detection of signals from a sample.

Possible uses for the probe according to the present invention include on-line inspection in the production of pharmaceuticals, detection of explosive or narcotics concealed within containers, cargo pallets or vehicles. With reduced shielding the probe could be used for the inspection of bags suspected of containing Improvised Explosive Devices (IEDs) without moving them and thus reducing the risk of setting off anti-handling devices.

It can be seen from the above description that the probe is designed so that it could be simple and lightweight in order to enable the probe to be easily portable in some embodiments. The probe may therefore be formed from a number of interconnectable body panel sections which simply clip together and/or are hinged to one another. The probe may then be broken down for transportation and then easily assembled for use. Disassembly would then simply involve unclipping the various body panel sections and possibly folding the sections together.

Alternatively, rather than breaking down into several parts the coil could be made of a number of loops connected by flexible conductive straps or braid which could be opened out to form the toroidal shape necessary for use but then could be pushed together for storage or transport. Figures 7A and 7B show one example of how this could be achieved. Figure 7A shows the probe fully opened in its normal working configuration. Figure 7B shows the probe partly closed wherein the ends of arm portions 3 and 4 have been moved away from each other so that some of the loops are pressed up against each other. Figure 7C shows the probe in its fully closed configuration with all loops pressed up against each other so that the probe is ready for transport or storage.

The present invention is a highly efficient magnetic structure and at the same time has very low susceptibility to generation and reception of extraneous signals. It is also more suited to shielding than other probe designs which enhances the rejection of extraneous signals while allowing the shield to be only a little larger than the probe itself hence minimising overall probe volume.

## Claims

1. A probe suitable for use in a magnetic resonance based material detection and/or analysis system, the probe comprising:
a probe body having a base portion and two arm portions, the arm portions extending from the two ends of the base portion so that their distal ends are directed towards one another and separated by a gap in which a sample of the material may be positioned,
inductance means adapted to receive electrical energy from the magnetic resonance based material detection and/or analysis system and produce a magnetic field within the inductance means, and
capacitance means connected to the inductance means,
wherein the base portion and the two arm portions of the probe body are hollow and the inductance means is provided around the base and arm portions of the probe body.

2. A probe as claimed in claim 1, wherein the probe body has a stretched toroidal shape having two semi-circular arm portions separated by a straight base portion with the gap provided opposite the base portion.

3. A probe as claimed in claim 1 or claim 2, wherein the probe body is formed in a substantially running track shape having two curved ends separated by parallel straight sections with the base portion forming one of the parallel straight sections, the two arm portions forming the respective curved ends and the gap positioned in the other of the parallel straight sides.

4. A probe as claimed in any one of the preceding claims, wherein the base portions and the two arm portions have rectangular cross-sections.

5. A probe as claimed in any one of the preceding claims, wherein the capacitance means are adjustable thereby allowing the resonant frequency of the system and hence the magnetic field within the probe body to be adjusted.

6. A probe according to any one of the preceding claims, wherein a plurality of adjustable capacitance means are provided connected to the inductance means and adjustment of the resonant frequency is accomplished by selectively connecting some or all of the plurality of adjustable capacitance means to the inductance means.

7. A probe according to any one of the preceding claims, wherein inductance adjustment means comprising means to adjust the cross-sectional area of a segment of the probe body are also provided allowing the frequency of the magnetic field within the inductance means to be adjusted.

8. A probe according to any one of the preceding claims, wherein the inductance means is a conductive layer covering substantially the entire outer surface of a substrate forming the probe body.

9. A probe according to any one of claims 1 to 7, wherein the inductance means is a conductive layer covering some of the outer surface of a substrate forming the probe body and includes regularly spaced cutout portions where no conductive layer is provided on the substrate.

10. A probe according to any one of the preceding claims, wherein the probe includes an outer electrically conductive electromagnetic shielding layer surrounding the inductance means and a door is provided in the shielding layer adjacent the gap to allow the introduction and removal of material samples to the gap.

11. A probe according to claim 10, wherein two doors are provided in the shielding layer adjacent respective opposite sides of the gap.

12. A probe according to claim 10 or claim 11, wherein two openings are provided in the shielding layer adjacent opposite sides of the gap and respective tunnel means are connected to the shielding layer surrounding the respective openings.

13. A probe according to any one of the preceding claims, wherein means are also provided to remove electrical energy from the magnetic field within the probe.

14. A probe according to any one of the preceding claims, wherein the base and arm portions of the probe body are formed in a number of releasably or flexibly connectable body panel sections to allow the probe to be repeatedly assembled and disassembled or expanded and compressed.

15. A magnetic resonance based material detection and/or analysis system comprising:
a probe according to any one of the preceding claims,
radio frequency pulse generating means connected to the probe to produce an applied magnetic field within the probe body,
sensing means for detecting a magnetic field produced by the material sample as a result of the applied magnetic field, and
control means to selectively energise either the radio frequency pulse generating means or the sensing means.

16. A magnetic resonance based material detection and/or analysis system as claimed in claim 15, wherein conveying means are also provided to transport material samples into and out of the gap in the probe.

17. A magnetic resonance based material detection and/or analysis system as claimed in claim 15 or claim 16, wherein the sensing means and/or the radio frequency pulse generating means are inductively, capacitively or directly coupled to the probe at respective single positions or at a plurality of respective positions.
